# EUROPEAN PATENT APPLICATION

(11) **EP 4 727 317 A1**
(43) Date of publication of application: **15.04.2026**
(21) Application number: 24776476.4
(22) Date of filing: 13.08.2024
(51) Int. Cl.: H10K 71/00

(54) **MULTI-LAYER MULTI-CAVITY LAMINATING MACHINE**

(30) Priority: 05.08.2024 CN 202411065251
(71) Applicant: Qinhuangdao Shengcheng Automation Equipment Co., Ltd., Qinhuangdao, Hebei 066006 (CN)
(72) Inventor: DONG, Weibing, Qinhuangdao, Hebei 066006 (CN); LI,k Shuopeng, Qinhuangdao, Hebei 066006 (CN); SHANG, Ju, Qinhuangdao, Hebei 066006 (CN); ZHOU, Mingzhen, Qinhuangdao, Hebei 066006 (CN); WANG, Yanguang, Qinhuangdao, Hebei 066006 (CN); XIN, Yuchen, Qinhuangdao, Hebei 066006 (CN); ZHANG, Cheng, Qinhuangdao, Hebei 066006 (CN); ZANG, Pengfei, Qinhuangdao, Hebei 066006 (CN)
(74) Representative: Valet Patent Services Limited
(86) International application number: PCT/CN2024/111663
(87) International publication number: WO 2026/031257

(57) **Abstract**

A multi-layer and multi-cavity laminating machine including a multi-layer feeding device, at least two multi-layer laminating devices, and a multi-layer finished product conveying device connected in sequence is provided. The number of multi-layer laminating devices are increased, and the laminating steps are carried out step by step. After completing the first laminating step, the solar cell module can be transported to the next multi-layer laminating device, so that the next solar cell module can be transported to the previous multi-layer laminating device, thereby improving production efficiency. In the same production time, it is possible to increase the production quantity or reduce the production time by producing the same quantity of products.

## Description

### TECHNICAL FIELD

The disclosure relates to the field of laminating machine technologies, and more specifically, to a multi-layer and multi-cavity laminating machine.

### BACKGROUND

Solar cell module laminators are one of the essential pieces of equipment required for the encapsulation of solar cell modules.

However, existing laminators are mostly multi-layer single-cavity types. For example, CN114834138B discloses a fully automatic stacked multi-layer laminator, which is a multi-layer single-cavity laminator with only one multi-layer laminating device. Each layer of solar cell modules can only be transported to the multi-layer finished product conveyance device after completion of the lamination process. The following solar cell module must wait until the previous lamination be completed before it can be fed into the multi-layer feeding device, resulting in reduced production efficiency.

Therefore, there is an urgent need for those skilled in the art to provide an efficient multi-layer and multi-cavity laminator.

### SUMMARY

In view of this, the disclosure provides a multi-layer and multi-cavity laminator to enhance production efficiency.

To achieve the above objective, the following technical schemes have been adopted.

A multi-layer and multi-cavity laminator is provided, which includes a multi-layer feeding device, at least two multi-layer laminating devices, and a multi-layer finished product conveyance device connected in sequence.

By adopting the above technical scheme, the following beneficial effects have been obtained.

By increasing the number of multi-layer laminating devices and carrying out the laminating steps progressively, solar cell modules can be transferred to the next multi-layer laminating device after completing the first laminating step. Consequently, the subsequent solar cell module can then be transported to the preceding multi-layer laminating device, thereby enhancing production efficiency. This allows for an increase in production volume within the same production time or reduces the production time required for the same volume of products.

Furthermore, adjacent multi-layer laminating devices are connected by a transitional conveyance device.

The beneficial effect of adopting the aforementioned further technical solution is to improve the compactness between devices and ensure continuous transportation.

Moreover, the transitional conveyance device includes a support frame and multiple conveyance roller sets, with the support frame placed between two adjacent multi-layer laminating devices; the multiple conveyance roller sets are mounted on the support frame and distributed at equal intervals from top to bottom.

Additionally, both the input end of the multi-layer feeding device and the output end of the multi-layer finished product conveyance device are equipped with lifting conveyance devices.

The beneficial effect of adopting the aforementioned further technical solution is to realize automatic layered loading or unloading, thus improving work efficiency.

Furthermore, the lifting conveyance device includes a lift, two lift frames, and two belt conveyor bodies. The two lift frames are mounted on the lift and are parallelly distributed vertically. The two belt conveyor bodies are respectively installed on the top of the two lift frames.

Further, the number of multi-layer laminating devices is two or three.

### BRIEF DESCRIPTION OF THE DRAWINGS

To more clearly illustrate the technical solutions in the embodiments of the present disclosure or existing technologies, a brief introduction to the drawings required for the descriptions of the embodiments or existing technologies will be provided. It is evident that the drawings described below are merely examples of the present invention. For those skilled in the art, other drawings can be derived from the provided figures without creative efforts.
FIG.1 is a structural schematic diagram of a multi-layer and multi-cavity laminator as provided in the first embodiment of the disclosure.
FIG.2 is a structural schematic diagram of a multi-layer and multi-cavity laminator as provided in the second embodiment of the disclosure.
FIG.3 is a structural schematic diagram of the transitional conveyance device of the disclosure.
FIG.4 is a structural schematic diagram of the lifting conveyance device and multi-layer feeding device of the disclosure.
FIG.5 is a partial structural schematic diagram of the lifting conveyance device provided by the disclosure.

### DETAILED DESCRIPTION OF THE EMBODIMENTS

The following description will clearly and completely detail the technical solutions of the embodiments of the present invention in conjunction with the drawings provided in these embodiments. It is evident that the described embodiments are only a portion of all possible embodiments and not the entirety. All other embodiments acquired by those skilled in the art without creative efforts, based on the embodiments of the present invention, fall within the scope of protection of this invention.

### Embodiment 1

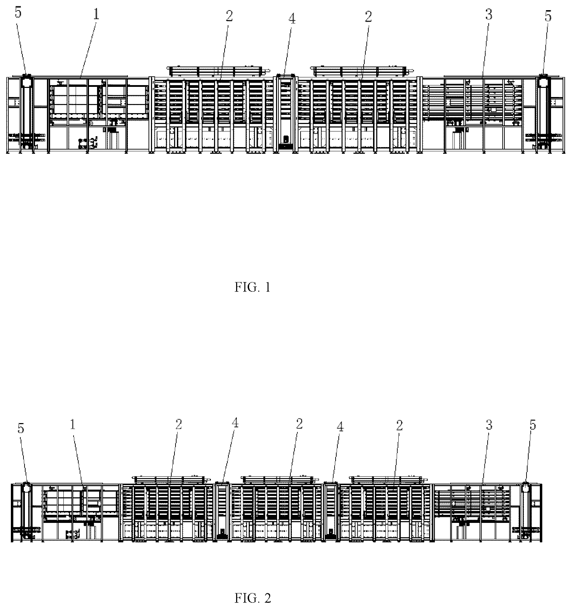

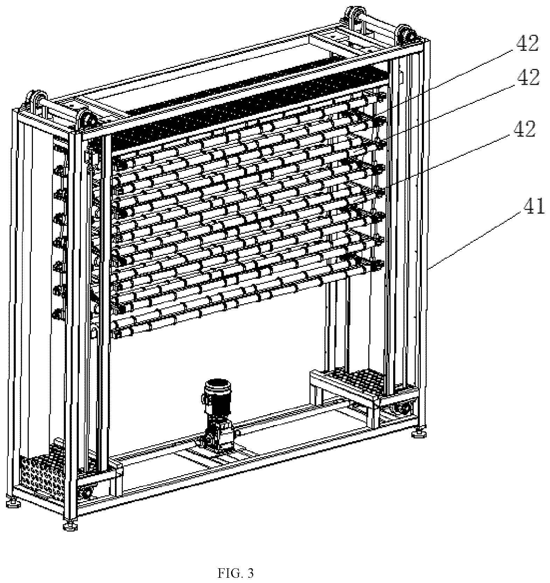

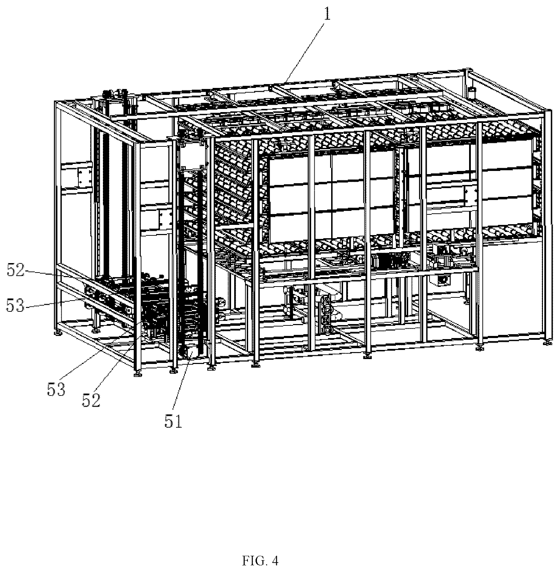

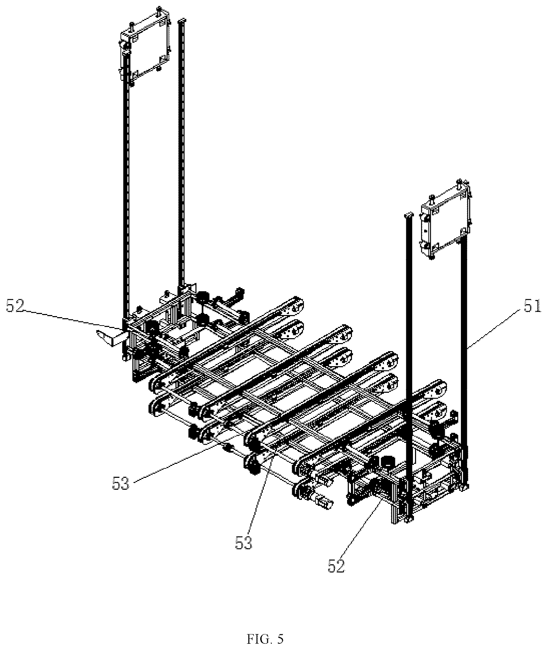

As shown in the Figures 1, 3, 4, and 5, a multi-layer and multi-cavity laminator including a multi-layer feeding device 1, at least two multi-layer laminating devices 2, and a multi-layer finished product conveyance device 3 connected in sequence is provided. In this embodiment, there are two multi-layer laminating devices 2. The structures of the multi-layer feeding device 1, multi-layer laminating devices 2, and multi-layer finished product conveyance device 3 are identical to those of an automatic stacked multi-layer laminator disclosed in CN114834138B and will not be elaborated herein. By increasing the number of multi-layer laminating devices 2, the lamination steps are carried out progressively. After completing the first lamination step, the solar cell module can be transferred to the next multi-layer laminating device 2, allowing the subsequent solar cell module to then be transported to the preceding multi-layer laminating device 2, thereby enhancing production efficiency. This allows for an increase in production volume within the same production time or reduces the production time required for the same volume of products.

To further optimize the technical solution of the present invention, adjacent multi-layer laminating devices 2 are connected by a transitional conveyance device 4, improving the compactness between devices and ensuring continuous transportation.

Specifically, the transitional conveyance device 4 includes a support frame 41 and multiple conveyor roller groups 42. The support frame 41 is placed between two adjacent multi-layer laminating devices 2. Multiple conveyor roller groups 42 are installed on the support frame 41 and distributed from top to bottom at equal intervals. It is evident that the multiple conveyor rollers of the conveyor roller group 42 can be connected through chain drive and driven by a single motor.

To further optimize the technical solution of the present invention, both the input end of the multi-layer feeding device 1 and the output end of the multi-layer finished product conveyance device 3 are equipped with lifting conveyance devices 5 to achieve automatic layered loading or unloading, thus improving work efficiency.

Specifically, the lifting conveyance device 5 includes a lift 51, two lift frames 52, and two belt conveyor bodies 53. Both lift frames 52 are installed on the lift 51 and are parallelly distributed vertically. The two belt conveyor bodies 53 are respectively mounted on the top of the two lift frames 52. In this embodiment, the belt conveyor body 53 specifically refers to the part of the belt conveyor excluding its frame.

### Embodiment 2

As shown in Figures 2, 3, 4, and 5, this embodiment of the invention discloses a multi-layer and multi-cavity laminator including a multi-layer feeding device 1, at least two multi-layer laminating devices 2, and a multi-layer finished product conveyance device 3 connected in sequence. In this embodiment, there are three multi-layer laminating devices 2. The structures of the multi-layer feeding device 1, multi-layer laminating devices 2, and multi-layer finished product conveyance device 3 are identical to those of an automatic stacked multi-layer laminator disclosed in CN114834138B and will not be elaborated herein. By increasing the number of multi-layer laminating devices 2, the lamination steps are carried out progressively. After completing the first lamination step, the solar cell module can be transferred to the next multi-layer laminating device 2, allowing the subsequent solar cell module to then be transported to the preceding multi-layer laminating device 2, thereby enhancing production efficiency. This allows for an increase in production volume within the same production time or reduces the production time required for the same volume of products.

To further optimize the technical solution of the present invention, adjacent multi-layer laminating devices 2 are connected by a transitional conveyance device 4, improving the compactness between devices and ensuring continuous transportation.

Specifically, the transitional conveyance device 4 includes a support frame 41 and multiple conveyor roller groups 42. The support frame 41 is placed between two adjacent multi-layer laminating devices 2. Multiple conveyor roller groups 42 are installed on the support frame 41 and distributed from top to bottom at equal intervals. It is evident that the multiple conveyor rollers of the conveyor roller group 42 can be connected through chain drive and driven by a single motor.

To further optimize the technical solution of the disclosure, both the input end of the multi-layer feeding device 1 and the output end of the multi-layer finished product conveyance device 3 are equipped with lifting conveyance devices 5 to achieve automatic layered loading or unloading, thus improving work efficiency.

Specifically, the lifting conveyance device 5 includes a lift 51, two lift frames 52, and two belt conveyor bodies 53. Both lift frames 52 are installed on the lift 51 and are parallelly distributed vertically. The two belt conveyor bodies 53 are respectively mounted on the top of the two lift frames 52. In this embodiment, the belt conveyor body 53 specifically refers to the part of the belt conveyor excluding its frame.

The descriptions of each embodiment in this specification are presented in a progressive manner, with each embodiment focusing on what differentiates it from the others. The similarities among the various embodiments are cross-referenced accordingly. Since the devices disclosed in the embodiments correspond to the methods disclosed therein, their descriptions are relatively brief, with relevant details referenced in the method sections.

The above explanations of the disclosed embodiments enable professionals in the field to implement or use the present invention. Numerous modifications to these embodiments will be apparent to those skilled in the art, and the general principles defined herein may be realized in other embodiments without departing from the spirit or scope of the present invention. Therefore, the present invention is not limited to the embodiments illustrated herein but is consistent with the broadest scope aligned with the principles and novel features disclosed in this document.

## Claims

1. A multi-layer, multi-cavity laminating machine, comprising a multi-layer feeding device, at least two multi-layer lamination devices and a multi-layer finished product conveyance device connected in sequence.

2. The multi-layer, multi-cavity laminating machine of claim 1, wherein the adjacent two multi-layer lamination devices are connected through a transitional conveyance device.

3. The multi-layer, multi-cavity laminating machine of claim 2, wherein the transitional conveyance device includes a support frame and multiple conveyor roller groups; the support frame is arranged between the adjacent two multi-layer lamination devices; multiple conveyor roller groups are installed on the support frame and are distributed from top to bottom at equal intervals.

4. The multi-layer, multi-cavity laminating machine of claim 1, wherein an input end of the multi-layer feeding device and an output end of the multi-layer finished product conveyance device both are equipped with lift conveyance devices.

5. The multi-layer, multi-cavity laminating machine of claim 4, wherein the lift conveyance device including an elevator, two lifting frames, and two belt conveyor bodies; both lifting frames are installed on the elevator and are parallelly distributed vertically; the two belt conveyor bodies are respectively mounted on the top of the two lifting frames.

6. The multi-layer, multi-cavity laminating machine of claim 1, wherein the number of multi-layer lamination devices being two or three.
